# EUROPEAN PATENT SPECIFICATION

(11) **EP 2 570 463 B1**
(45) Date of publication and mention of the grant of the patent: **25.02.2015**
(21) Application number: 12182163.1
(22) Date of filing: 29.08.2012
(51) Int. Cl.: C09D 183/04

(54) **Method of producing cured thin film using photocurable silicone resin composition**
Verfahren zur Herstellung einer gehärteten Dünnschicht mittels lichthärtbarer Siliciumharzzusammensetzung
Procédé de production d'un film mince durci utilisant la composition de résine de silicone photodurcissable

(30) Priority: 16.09.2011 JP 2011203602
(43) Date of publication of application: 20.03.2013
(73) Proprietor: Shin-Etsu Chemical Co., Ltd., Tokyo (JP)
(72) Inventor: Inafuku, Kenichi, Annaka-shi, Gunma (JP); Wakao, Miyuki, Annaka-shi, Gunma (JP); Kashiwagi, Tsutomu, Annaka-shi, Gunma (JP)
(74) Representative: von Füner, Nicolai

(56) References cited:
- EP-A1- 2 463 334
- JP-A- 2010 047 646
- US-A- 5 738 976

## Description

### 1. Field of the Invention

The present invention relates to a method of producing a cured thin film using a photocurable silicone resin composition. More specifically, the invention relates to a method of producing a cured thin film that comprises exposing a photocurable silicone resin composition to light having a specific wavelength to generate a semi-cured state, and then performing heating to achieve complete curing. Further, the present invention also relates to a cured thin film obtained using this method.

### 2. Description of the Prior Art

Silicone resins and silicone rubbers exhibit excellent heat resistance, light resistance and insulating properties, and also yield transparent molded articles and cured products, and are therefore widely used for all manner of optical applications and electronic devices.

Addition-curable silicone resin compositions that cure upon heating generally employ a platinum catalyst as a curing catalyst. In such silicone resin compositions, because the platinum catalyst exhibits activity immediately following preparation of the composition, a curing retarder must be added to the composition to ensure satisfactory pot life for the silicone resin composition. However, as a result, the curing rate of the silicone resin composition slows. This slower curing rate is disadvantageous when forming specific molded articles from the silicone resin composition, for example thin films having a specific thickness or a specific pattern. Namely, because the curing process takes time, the composition may flow during the period prior to complete curing being achieved by heating, increasing the likelihood of variation in the desired thickness or pattern. Accordingly, tests have been conducted into employing a silicone resin having a three dimensional network structure or adding a large amount of additives in order to reduce the fluidity of the composition, or curing the composition rapidly within a short period of time using a high-temperature heating oven. However, when heating is performed at high temperature, control of the production line is not easy, and such high-temperature heating is not entirely satisfactory for obtaining molded articles of the desired dimensions and shape.

On the other hand, silicone resin compositions that cure upon irradiation with light do not undergo reaction in the absence of light, and therefore a curing retarder need not be added. Further, because the curing reaction proceeds readily, control of the production line is easy, and the energy required is minimal. Moreover, because small-scale apparatus are adequate, significant cost reductions can be expected for the production process.

An example of a known photocurable silicone resin composition is a resin composition comprising a (meth)acrylate polymer, a (meth)acryloyloxy group-containing silicone resin, or a (meth)acryloyloxy group-containing photocurable resin and a photopolymerization initiator, and the use of this resin composition for forming a top coat layer for protecting the surface of a plastic molded article has already been disclosed (see Patent Document 1).

Further, a photocurable composition comprising a polysiloxane-based compound having a polyhedral siloxane structure containing a photopolymerizable functional group and an SiH group, an alkenyl group-containing compound, a photopolymerization initiator and a hydrosilylation catalyst is also known, and it has been reported that this composition has lithography properties, and can be used in the formation of passivation films or gate insulation films for thin-film transistors (see Patent Document 2).

Furthermore, a photocurable organopolysiloxane composition comprising a linear organopolysiloxane having (meth)acryloyloxy groups at both terminals, an N,N-dialkyl-substituted acrylamide and/or acryloylmorpholine as a radical polymerizable monomer, and a photopolymerization initiator is also known (see Patent Document 3).

However, the compositions disclosed in Patent Documents 1 to 3 have weak crosslinking points within the resulting cured product, and because these crosslinking points are susceptible to damage by heat or light, and can act as the starting point for resin decomposition, the heat resistance and light resistance of cured products in the form of thin films tends to be unsatisfactory.

A method of producing a silicone coating or silicone molded article has been reported that involves applying a coating of, or molding, a photocrosslinkable silicone mixture comprising an organopolysiloxane having an aliphatic multiple bond, an organosilicon compound having at least two SiH groups within each molecule, and a platinum cyclopentadienyl complex that can be activated by light, heating the mixture at 40 to 250°C, either before or after application or molding, to reduce the viscosity of the mixture and improve the workability, and subsequently irradiating the mixture with light of 200 to 500 nm (see Patent Document 4). However, in this method, because short-wavelength ultraviolet light is not cut, the catalyst tends to be deactivated by the short-wavelength ultraviolet light when the applied coating is thin, which increases the likelihood of unsatisfactory curing. Accordingly, reducing the thickness of the coating is problematic.
Patent Document 1: JP 2011-016871 A
Patent Document 1: JP 2010-254927 A
Patent Document 3: JP 2008-031307 A
Patent Document 4: JP 2011-12264 A

Document EP 2 463 334 discloses a process which is almost identical to the present process, with the difference that it does not make reference to the use of a mask to create a pattern. Documents US 5 738 976 and JP 2010 disclose methods which are similar to the present method, except that the wavelengths under 300 nm are not removed. Document US2011143092 discloses patterned films with a thickness of more than 10 micrometers which are prepared by a process similar to the present process but not from organopolysiloxanes comprising unsatured groups.

### SUMMARY OF THE INVENTION

The present invention addresses the issues outlined above, and has an object of providing a method of producing a cured thin film that enables a desired cured thin film to be formed easily and with superior precision, by using a curable silicone resin composition which is photocurable and therefore exhibits lithography properties, and can be cured by a combination of photocuring and heat curing.

In other words, the present invention provides a method of producing a cured thin film by curing a photocurable silicone resin composition comprising:
(A) an organopolysiloxane having two or more alkenyl groups within each molecule,
(B) an organohydrogenpolysiloxane having two or more hydrogen atoms bonded to silicon atoms within each molecule, in an amount that is sufficient to provide from 0.1 to 4.0 mols of hydrogen atoms bonded to silicon atoms per 1 mol of alkenyl groups within the composition, and
(C) an effective amount of a photoactive catalyst,
   wherein the method comprises:
   (i) obtaining a coating film by applying the silicone resin composition to a substrate,
   (ii) obtaining a thin film in a semi-cured state by partially curing the coating film by irradiation with a light, that is irradiated through a mask that is used for forming a pattern, thus forming a patterned thin film in a semi-cured state, the thin film being then subjected to a developing treatment to remove uncured portions and
   (iii) heating the thin film in a semi-cured state to achieve complete curing,
and wherein the spectrum of the light irradiated in step (ii) has a maximum peak in a wavelength region from 300 nm to 400 nm, and
the spectral irradiance of light of any wavelength in the spectrum within the wavelength region shorter than 300 nm is not more than 5% of the spectral irradiance of light of the maximum peak wavelength.

The present invention also provides a cured thin film obtained using the above method, and a semiconductor device provided with such a cured thin film.

By using a combination of a photocuring step and a heat curing step, the method of producing a cured thin film according to the present invention is able to form a silicone resin-based cured film having a desired thickness and shape easily and with superior precision. The method is also useful for forming a high-precision pattern using the same operations as those used for an n-type photoresist.

The photocurable silicone resin composition used in the method of the present invention is inactive and highly stable when not irradiated with light, and has an excellent pot life, and therefore the method of the present invention also offers excellent workability. Moreover, because the resulting thin film exhibits excellent heat resistance and optical transparency, it can be used favorably as an encapsulating material for optical semiconductor elements such as light emitting diodes.

### BRIEF DESCRIPTION OF THE DRAWINGS

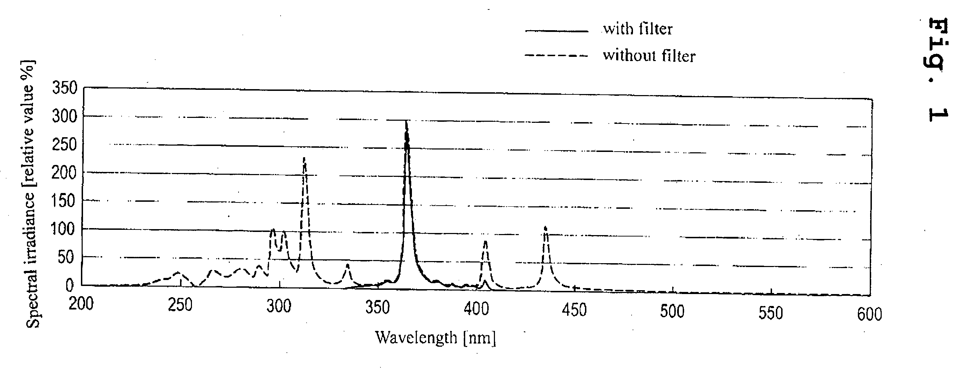

FIG. 1 illustrates, as a solid line, the emission spectrum of a light irradiated through a band pass filter in an example 1, and illustrates, as a dashed line, the emission spectrum of the light prior to passage through the band pass filter, which was used in comparative examples 2 and 3.

### DETAILED DESCRIPTION OF THE PREFERRED EMBODIMENTS

### - Method of Producing Cured Thin Film -

### <Photocurable Silicone Resin Composition>

First is a description of the photocurable silicone resin composition used in the method of the present invention.

This photocurable silicone resin composition comprises the components (A) to (C) described below as essential components. Each of these components is described below in further detail.

### - (A) Alkenyl Group-Containing Organopolysiloxane:

In the present invention, the term "alkenyl group" used in relation to the component (A) includes non-cyclic alkenyl groups and cyclic alkenyl groups (so-called cycloalkenyl groups).

The component (A) is an organopolysiloxane that contains at least two alkenyl groups within each molecule, and examples of the alkenyl groups include alkenyl groups of 2 to 8 carbon atoms, and particularly 2 to 6 carbon atoms. Specific examples of the alkenyl groups include non-cyclic alkenyl groups such as a vinyl group, allyl group, propenyl group, isopropenyl group, butenyl group, pentenyl group and hexenyl group, and cycloalkenyl groups such as a cyclohexenyl group. Among these groups, a vinyl group or allyl group is preferred. The organopolysiloxane used in the present invention may exist in a solid state through to a viscous resin state at normal temperatures, but from the viewpoints of workability and curability of the composition, the viscosity at 23°C is preferably within a range from 10 to 1,000,000 mPa·s, and more preferably from 100 to 100,000 mPa·s. Accordingly, in those cases where the organopolysiloxane is a solid at 23°C, a solvent is preferably used to adjust the viscosity to a value within the above range. The viscosity of the organopolysiloxane can be measured using a rotational viscometer. Examples of solvents that may be used in combination with the organopolysiloxane include toluene, heptane and cyclohexane. The amount of the solvent may be adjusted appropriately so that, upon mixing with the organopolysiloxane, the viscosity of the resulting solution satisfies the above range.

The organopolysiloxane preferably has a three dimensional network structure comprising SiO_{4/2} units (hereafter referred to as "Q units") and R₃SiO_{1/2} units (hereafter referred to as "M units"). The organopolysiloxane may also comprise R₂SiO units (hereafter referred to as "D units") and/or RSiO_{3/2} units (hereafter referred to as "T units"), preferably R₂SiO units. The ratio between the M units and the Q units within the organopolysiloxane, reported as a molar ratio, is preferably within a range from 1:0.5 to 1:3, and more preferably from 1:0.6 to 1:2.5. When the organopolysiloxane includes D units and/or T units, these units preferably represent 30 to 70 mol%, and more preferably 40 to 60 mol%, of all the siloxane units. Further, the organopolysiloxane used in the present invention has a polystyrene-equivalent weight-average molecular weight, determined by GPC, that is preferably within a range from 10 to 1,000,000, and more preferably from 100 to 100,000.

In the above units, each R independently represents an unsubstituted or substituted monovalent hydrocarbon group of 1 to 10 carbon atoms, and preferably an unsubstituted or substituted monovalent hydrocarbon group of 1 to 6 carbon atoms, provided that at least two of the groups represented by R in each molecule represent alkenyl groups. Specific examples of the monovalent hydrocarbon group include alkyl groups such as a methyl group, ethyl group, propyl group, isopropyl group, butyl group, isobutyl group, tert-butyl group, pentyl group, neopentyl group, hexyl group, octyl group, nonyl group and decyl group; a cyclohexyl group; aryl groups such as a phenyl group, tolyl group, xylyl group and naphthyl group; aralkyl groups such as a benzyl group, phenylethyl group and phenylpropyl group; alkenyl groups such as a vinyl group, allyl group, propenyl group, isopropenyl group, butenyl group, pentenyl group, hexenyl group and octenyl group; a cyclohexenyl group; and groups in which some or all of the hydrogen atoms within one of the above hydrocarbon groups have each been substituted with a halogen atom such as a fluorine atom, bromine atom or chlorine atom, or a cyano group or the like, including halogen-substituted alkyl groups such as a chloromethyl group, chloropropyl group, bromoethyl group and trifluoropropyl group, and a cyanoethyl group.

The aforementioned organopolysiloxane having a three dimensional network structure can be synthesized easily by combining the compounds that act as the unit sources for the above M units, Q units, D units and T units in the amounts required to achieve the above molar ratio, and then, for example, performing a co-hydrolysis reaction in the presence of an acid. Silane compounds represented by a formula (1) shown below may be used as the units sources for the M units, Q units, D units and T units.

RₙSiX₄₋ₙ (1)

In this formula, R is the same as defined above, X represents a halogen atom such as a chlorine atom, bromine atom or fluorine atom, or an alkoxy group of 1 to 4 carbon atoms, and n represents an integer of 0 to 3. The halogen atom for X is preferably a chlorine atom.

Specific examples of the silane compound represented by the formula (1) include methyltrichlorosilane, vinyltrichlorosilane, methyltrimethoxysilane, methyltriethoxysilane, vinylmethyldichlorosilane, vinylmethyldimethoxysilane, vinylmethyldiethoxysilane, dimethyldichlorosilane, trimethylmethoxysilane, trimethylchlorosilane, trivinylchlorosilane, vinyldimethylchlorosilane, tetrachlorosilane, tetramethoxysilane and tetraethoxysilane. For the Q unit source, sodium silicate, alkyl silicates and polyalkyl silicates can also be used.

The component (A) used in the present invention may be a mixture of an aforementioned organopolysiloxane having a three dimensional network structure and a linear organopolysiloxane. The linear organopolysiloxane is preferably a structure in which the main chain is composed of repeating diorganosiloxane units, and both molecular chain terminals are blocked with triorganosiloxy groups, and among such structures, a linear organopolysiloxane represented by a general formula (2) shown below is particularly desirable. The linear organopolysiloxane may include a small amount of branched structures within the molecular chain.

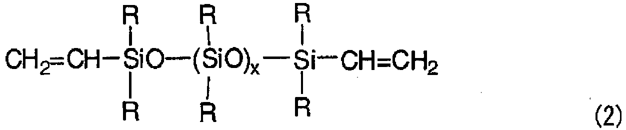

In the above formula, R is the same as defined above, and x represents 0 or a positive integer, is preferably an integer within a range from 1 to 10,000, and more preferably from 5 to 2,000, and is an integer that yields a viscosity for the organopolysiloxane at 23°C that is within a range from 10 to 1,000,000 mPa·s, and preferably from 100 to 100,000 mPa·s.

When the component (A) includes a linear organopolysiloxane, the amount of the linear organopolysiloxane within the component (A) is preferably within a range from 20 to 70% by mass, and more preferably from 30 to 60% by mass. If the amount of the organopolysiloxane having a three dimensional network structure is too small, then the strength of the cured product may weaken, whereas if the amount is too large, then the viscosity of the resin composition increases, and the cured product may become prone to cracking.

### - (B) Organohydrogenpolysiloxane:

The component (B) is an organohydrogenpolysiloxane having at least two, preferably at least three, more preferably from 3 to 1,000, still more preferably from 3 to 500, still more preferably from 3 to 200, and most preferably from 4 to 100, hydrogen atoms bonded to silicon atoms (namely, SiH groups) within each molecule. A cured product is formed when the SiH groups in the organohydrogenpolysiloxane react with the alkenyl groups in the component (A). There are no particular limitations on the positions within the molecule of the hydrogen atoms bonded to silicon atoms, and the SiH groups may be positioned at the molecular chain terminals, at non-terminal positions within the molecular chain, or at both these positions. There are no particular limitations on the molecular structure of the organohydrogenpolysiloxane of the component (B) provided the conditions described above are satisfied, and compounds having linear, cyclic, branched or three dimensional network structures, preferably linear structure, can be used.

The number of silicon atoms within one molecule of the organohydrogenpolysiloxane (namely, the polymerization degree) is typically within a range from 2 to 1,000, preferably from 3 to 500, and more preferably from 4 to 150. The viscosity at 23°C is preferably within a range from 0.1 to 100,000 mPa·s, and more preferably from 0.5 to 5,000 mPa·s, and an organohydrogenpolysiloxane that is liquid at room temperature (23°C) can be used particularly favorably.

Examples of this organohydrogenpolysiloxane include compounds represented by an average composition formula (3) shown below.

R¹_{b}H_{c}SiO_{(4-b-c)/2} (3)

In this formula, R¹ represents an unsubstituted or substituted monovalent hydrocarbon group of 1 to 10 carbon atoms that does not contain an alkenyl group or other aliphatic unsaturated bond, b represents a number from 0.7 to 2.1, and c represents a number from 0.001 to 1.0, provided that b+c represents a number within a range from 0.8 to 3.0. b is preferably a number from 1.0 to 2.0, c is preferably a number from 0.01 to 1.0, and b+c is preferably a number within a range from 1.5 to 2.5.

Examples of the unsubstituted or substituted monovalent hydrocarbon group represented by R¹ include alkyl groups such as a methyl group, ethyl group, propyl group, isopropyl group, butyl group, isobutyl group, tert-butyl group, pentyl group, neopentyl group, hexyl group, octyl group, nonyl group and decyl group; cycloalkyl groups such as a cyclohexyl group; aryl groups such as a phenyl group, tolyl group, xylyl group and naphthyl group; aralkyl groups such as a benzyl group, phenylethyl group and phenylpropyl group; and groups in which some or all of the hydrogen atoms within one of the above hydrocarbon groups have each been substituted with a halogen atom such as a fluorine atom, bromine atom or chlorine atom, such as a chloromethyl group, chloropropyl group, bromoethyl group and trifluoropropyl group. Among these unsubstituted and substituted monovalent hydrocarbon groups, an alkyl group or aryl group is preferred, and a methyl group or phenyl group is particularly desirable.

Organohydrogenpolysiloxanes having a branched or three dimensional network structure can be obtained, for example, either by hydrolysis of a chlorosilane compound such as R¹SiCl₃, R¹SiHCl₂, (R¹)₃SiCl, (R¹)₂SiCl₂ or (R¹)₂SiHCl (wherein R¹ is the same as defined above), or by equilibration of the siloxane obtained upon hydrolysis.

Examples of organohydrogenpolysiloxanes having a branched or three dimensional network structure include tris(dimethylhydrogensiloxy)methylsilane, tris(dimethylhydrogensiloxy)phenylsilane, copolymers composed of (CH₃)₂HSiO_{1/2} units, (CH₃)₃SiO_{1/2} units and SiO_{4/2} units, copolymers composed of (CH₃)₂HSiO_{1/2} units and SiO_{4/2} units, and copolymers composed of (CH₃)₂HSiO_{1/2} units, SiO_{4/2} units and (C₆H₅)₃SiO_{1/2} units, and more specific examples include the compounds shown below.

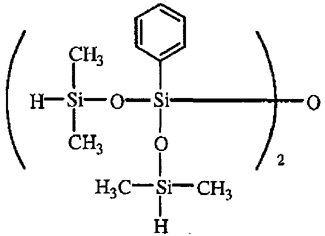

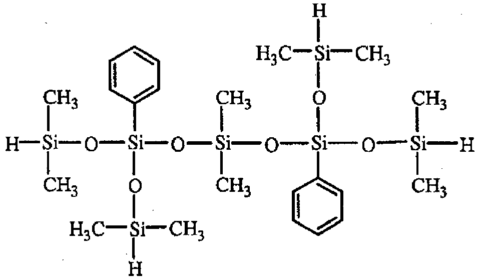

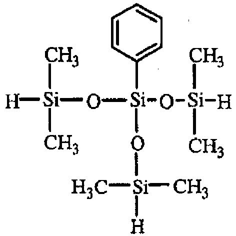

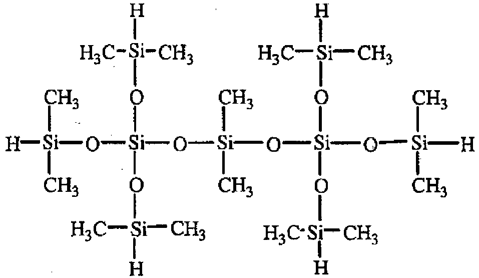

Specific examples of cyclic and non-cyclic organohydrogenpolysiloxanes include 1,1,3,3-tetramethyldisiloxane, 1,3,5,7-tetramethylcyclotetrasiloxane, tris(hydrogendimethylsiloxy)methylsilane, methylhydrogencyclopolysiloxane, cyclic copolymers of methylhydrogensiloxane and dimethylsiloxane, methylhydrogenpolysiloxane with both terminals blocked with trimethylsiloxy groups, copolymers of dimethylsiloxane and methylhydrogensiloxane with both terminals blocked with trimethylsiloxy groups, dimethylpolysiloxane with both terminals blocked with dimethylhydrogensiloxy groups, copolymers of dimethylsiloxane and methylhydrogensiloxane with both terminals blocked with dimethylhydrogensiloxy groups, copolymers of methylhydrogensiloxane and diphenylsiloxane with both terminals blocked with trimethylsiloxy groups, copolymers of methylhydrogensiloxane, diphenylsiloxane and dimethylsiloxane with both terminals blocked with trimethylsiloxy groups, copolymers of methylhydrogensiloxane, methylphenylsiloxane and dimethylsiloxane with both terminals blocked with trimethylsiloxy groups, copolymers of methylhydrogensiloxane, dimethylsiloxane and diphenylsiloxane with both terminals blocked with dimethylhydrogensiloxy groups, and copolymers of methylhydrogensiloxane, dimethylsiloxane and methylphenylsiloxane with both terminals blocked with dimethylhydrogensiloxy groups.

Further, examples of linear organohydrogenpolysiloxanes include structures of the formula shown below.

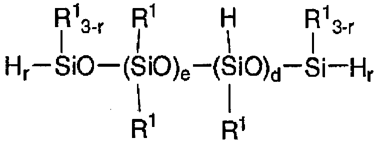

In this formula, e and d are integers that satisfy 0≤e≤998, 0≤d≤998 and 0<e+d<998, and preferably satisfy 1<e+d<298 and more preferably 2<e+d<148, and d is preferably more than 0 (d>0), more preferably not less than 2 (d≧2), r represents an integer of 0 to 3, preferably r is 0, and R¹ is the same as defined above, provided that the organohydrogenpolysiloxane has at least two hydrogen atoms bonded to silicon atoms within each molecule.

The amount added of the organohydrogenpolysiloxane of the component (B) is sufficient to provide from 0.1 to 4.0 mols, preferably from 0.8 to 3.0 mols, and more preferably from 0.9 to 2.0 mols, of hydrogen atoms bonded to silicon atoms within the component (B) per 1 mol of all the alkenyl groups within the composition. If the amount of the component (B) is too large, then a large amount of unreacted SiH groups remain in the cured product, which can cause a change in the physical properties of the cured product over time, and is therefore undesirable. In this description, if a component (D) described below is included within the composition as another component that contains alkenyl groups, then the expression "all the alkenyl groups within the composition" refers to the combination of the alkenyl groups within the component (D) and the alkenyl groups within the component (A), whereas if there are no components containing alkenyl groups besides the component (A), then "all the alkenyl groups" refers to only the alkenyl groups within the component (A).

### - (C) Photoactive Catalyst:

There are no particular limitations on the component (C), provided it is a catalyst that exhibits photoactivity, but photoactive platinum group metal catalysts or nickel-based catalysts are preferred. Examples of the photoactive platinum group metal catalysts include platinum-based, palladium-based and rhodium-based catalysts, and among these, platinum-based catalysts are preferred. Specific examples of photoactive platinum-based catalysts include β-diketonate platinum complex catalysts such as trimethyl(acetylacetonato)platinum complex, trimethyl(3,5-heptanedionate)platinum complex, trimethyl(methylacetoacetate)platinum complex, bis(2,4-pentanedionato)platinum complex, bis(2,4-hexanedionato)platinum complex, bis(2,4-heptanedionato)platinum complex, bis(3,5-heptanedionato)platinum complex, bis(1-phenyl-1,3-butanedionato)platinum complex, bis(1,3-diphenyl-1,3-propanedionato)platinum complex and bis(acetylacetonato) platinum complex. Further, trimethyl(methylcyclopentadienyl)platinum can also be used. Examples of the photoactive nickel-based catalysts include bis(2,4-pentanedionato)nickel complex. One of these catalysts may be used alone, or two or more catalysts may be used in combination. Of the various possibilities, the catalyst used in the curing method of the present invention is preferably bis(2,4-pentanedionato)platinum complex or a so-called bis(acetylacetonato)platinum(II) complex.

The amount added of the component (C) need only be an effective amount, and a typical amount, calculated as an equivalent amount (by mass) of the platinum group metal relative to the combined mass of the component (A) and the component (B), is within a range from 0.1 to 1,000 ppm, and preferably from 0.5 to 200 ppm. Provided the amount is within the above range, the photocurable silicone resin composition can be cured within a short period of time.

### - Optional Components:

Where necessary, the composition used in the present invention may also include other optional components besides the components (A) to (C), provided the inclusion of these optional components does not impair the objects and effects of the present invention.

### -- (D) Adhesion Assistant:

Examples of adhesion assistants that may be added include linear or cyclic organosiloxane oligomers, and organooxysilyl-modified isocyanurate compounds and/or hydrolysis-condensation products thereof (organosiloxane-modified isocyanurate compounds), wherein each molecule contains from 4 to 50, and preferably from 4 to 20, silicon atoms, and also contains at least two, and preferably two or three, functional groups selected from among a hydrogen atom bonded to a silicon atom (SiH group), an alkenyl group bonded to a silicon atom (such as a -Si-CH=CH₂ group), an alkoxysilyl group (such as a trimethoxysilyl group), an epoxy group (such as a glycidoxypropyl group or 3,4-epoxycyclohexylethyl group) and a (meth)acrylate group, wherein these compounds falling under component (A) or (B) are excluded. One of these adhesion assistants may be used alone, or two or more may be used in combination.

Specific examples of the adhesion assistant include the compounds shown below.

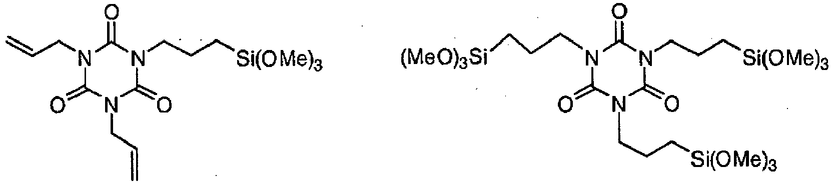

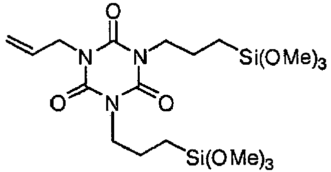

Further, besides the compounds described above, a compound shown below may also be used as an adhesion assistant.

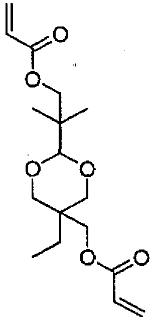

The amount added of the adhesion assistant is preferably within a range from 0.1 to 20 parts by mass, more preferably from 0.2 to 10 parts by mass, and still more preferably from 0.5 to 5 parts by mass, per 100 parts by mass of the component (A). If the amount of the adhesion assistant is too large, then the hardness of the cured product may be adversely affected, and surface tack may be increased.

### -- Other Optional Components:

Other compounds that have the effect of retarding or controlling the curing reaction may also be added as optional components. Any of the various conventional compounds that have been proposed for this role may be used, and specific examples include phosphorus-containing compounds such as triphenylphosphine, nitrogen-containing compounds such as tributylamine, tetramethylethylenediamine and benzotriazole, sulfur-containing compounds, acetylene-based compounds, compounds having two or more alkenyl groups, hydroperoxy compounds, and maleic acid derivatives. The degree of the curing delay effect provided by these compounds varies significantly depending on the chemical structure of the compound. Accordingly, the amount added should be adjusted to the optimum amount for the particular compound being used. Generally, if the amount added is too small, then long-term storage stability at room temperature cannot be achieved, whereas if the amount added is too large, curing may be inhibited.

Other optional components that may be used include inorganic fillers such as fumed silica, crystalline silica, precipitated silica, hollow fillers, polyorganosilsesquioxanes, fumed titanium dioxide, magnesium oxide, zinc oxide, iron oxide, aluminum hydroxide, magnesium carbonate, calcium carbonate, zinc carbonate, layered mica, carbon black, diatomaceous earth and glass fiber; and fillers prepared by subjecting the above inorganic fillers to surface treatment with an organosilicon compound such as an organoalkoxysilane compound, organochlorosilane compound, organosilazane compound or low-molecular weight siloxane compound. Further, silicone rubber powders and silicone resin powders may also be used. These fillers may be added as appropriate, in amounts that do not impair the effects of the present invention.

Moreover, the photocurable silicone resin composition used in the present invention may also include, for example for the purpose of adjusting the hardness of the thin film in a semi-cured state obtained in step (ii), an organopolysiloxane containing one hydrogen atom bonded to a silicon atom (SiH group) in each molecule and/or a non-crosslinkable organopolysiloxane that contains neither a hydrogen atom nor an alkenyl group bonded to a silicon atom. Furthermore, organic solvents, creep hardening inhibitors, heat resistance-imparting agents, flame retardants, plasticizers, thixotropy-imparting agents, pigments, dyes and fungicides and the like may also be added to the composition as required, in amounts that do not impair the effects of the present invention.

The photocurable silicone resin composition used in the present invention is prepared by combining the components described above in the prescribed composition ratio, and then mixing the components uniformly together via a normal method using a planetary mixer or Shinagawa mixer. The viscosity of the composition used in the present invention, measured at 23°C using a rotational viscometer, is preferably within a range from 10 to 1,000,000 mPa·s, and more preferably from 100 to 100,000 mPa·s.

### <Step (i)>

In this step, the photocurable silicone resin composition is applied to a substrate to form a coating film.

There are no particular limitations on the method used for applying the composition, and examples include a spin coating method, dip coating method, spray coating method, roll coating method, knife coating method, curtain coating method, electrostatic coating method, CVD method or drop casting method.

Examples of the material of the substrate include metals such as silver, ceramics such as alumina, and organic materials such as PPA.

### <Step (ii)>

In this step, the coating film obtained in step (i) is irradiated with light to obtain a thin film in a semi-cured state.

The light that is irradiated onto the coating film:
(a) has a spectrum having a maximum peak in the wavelength region from 300 nm to 400 nm, and
(b) has a spectral irradiance for light of any wavelength in the spectrum within the wavelength region shorter than 300 nm that is not more than 5%, preferably not more than 1%, more preferably not more than 0.1%, and most preferably 0 %, of the spectral irradiance of light of the maximum peak wavelength.

The spectral irradiance for light of any wavelength within the wavelength region shorter than 300 nm is preferably as close to 0 as possible. If light that includes a wavelength which is within the wavelength region shorter than 300 nm and has a spectral irradiance that is greater than 5% of the spectral irradiance of light of the maximum peak wavelength is irradiated onto the coating film, then a portion of the photoactive catalyst of the component (C) is deactivated, making curing of the resin composition difficult.

Provided the light that is irradiated onto the coating film satisfies the conditions (a) and (b) described above, there are no limitations on the spectrum of the light emitted by the light source (the emission spectrum), and for example, the conditions (a) and (b) may be satisfied by passing the light through an optical filter.

The dose (intensity) of the light irradiated onto the coating film, reported as an integral of light, is preferably within a range from 100 to 100,000 mJ/cm², more preferably from 100 to 10,000 mJ/cm², and still more preferably from 100 to 5,000 mJ/cm². Provided the irradiation dose (intensity) satisfies the above range, the photocurable silicone resin composition can be cured to a semi-cured state by performing light irradiation for an extremely short period of time.

Although there are no particular limitations on the type of light irradiated onto the coating film, ultraviolet light is preferred. The irradiated ultraviolet light may be light having a plurality of emission spectra or light having a single emission spectrum. Further, the single emission spectrum may be a broad spectrum in the region from 300 to 400 nm. The light having a single emission spectrum has a peak (namely, a maximum peak wavelength) within a range from 300 to 400 nm, and preferably from 350 to 380 nm. Examples of light sources that emit this type of light include ultraviolet light emitting semiconductor light sources such as an ultraviolet light emitting diode (UV-LED) and an ultraviolet light emitting semiconductor laser.

Examples of light sources that emit light having a plurality of emission spectra include lamps such as a metal halide lamp, xenon lamp, carbon-arc lamp, chemical lamp, sodium lamp, low-pressure mercury lamp, high-pressure mercury lamp and ultra high-pressure mercury lamp, gas lasers such as a nitrogen gas laser, liquid lasers using organic dye solutions, and solid-state lasers using an inorganic single crystal containing a rare-earth ion. For example, a conveyor-type UV irradiation apparatus can be used.

In those cases where the emission spectrum of the light has a peak in the wavelength region shorter than 300 nm, or those cases where the emission spectrum includes a wavelength within the wavelength region shorter than 300 nm that has a spectral irradiance that is greater than 5% of the spectral irradiance of light of the maximum peak wavelength within the emission spectrum (for example, where the emission spectrum is very broad and spans a wide wavelength region), an optical filter may be used to remove light having a wavelength within the wavelength region shorter than 300 nm. Such optical filtering can be used to ensure that the spectral irradiance at any wavelength within the wavelength region shorter than 300 nm that is not more than 5%, preferably not more than 1%, more preferably not more than 0.1%, and most preferably 0%, of the spectral irradiance at the maximum peak wavelength. In those cases where a plurality of peaks exist in the emission spectrum within the wavelength region from 300 to 400 nm, the peak wavelength that exhibits the largest irradiance is deemed to be the maximum peak wavelength.

There are no particular limitations on the optical filter, provided it is capable of cutting wavelengths shorter than 300 nm, and conventional filters may be used. For example, a 365 nm band pass filter may be used. The irradiance and spectral distribution of ultraviolet light can be measured using a spectroradiometer such as a USR-45D device (manufactured by Ushio Inc.).

The time period for which the light is irradiated onto the coating film of the photocurable silicone resin composition may be extremely short. For example, if the coating film is irradiated for 0.5 to 10 seconds, and particularly for 1 to 5 seconds, then the irradiated portions of the photocurable silicone resin composition will cure over the subsequent 10 to 600 seconds, and particularly 60 to 300 seconds, forming a semi-cured state.

In the present invention, the expression "semi-cured state" describes a state in which the curing reaction of the aforementioned photocurable silicone resin composition has partially progressed, so that the resin composition has lost fluidity and become insoluble in the solvent used in a developing treatment described below. Accordingly, the curing reaction has not proceeded to completion. The resin composition is completely cured by performing heating in step (iii), but until the curing reaction is completed by this heating, the semi-cured film composed of the resin composition is able to maintain the desired shape, without flowing.

In the present invention, when light is irradiated onto the coating film during step (ii), the light is irradiated through a mask that is used for forming a pattern, thus forming a patterned thin film in a semi-cured state, and by subsequently subjecting the thin film to a developing treatment to remove the uncured portions, and then supplying the thin film in a semi-cured state to step (iii), a patterned cured thin film can be formed.

Specifically, the developing treatment can be performed by washing the exposed film with an appropriate solvent. This washing removes the unexposed portions of the film, so that only the exposed semi-cured portions of the film remain as a pattern. Examples of the solvent used as the developing liquid include aromatic hydrocarbon solvents such as benzene, toluene, xylene, mesitylene, ethylbenzene and diethylbenzene; aliphatic or alicyclic hydrocarbon solvents such as pentane, hexane, heptane, octane, cyclohexane, methylcyclohexane, decahydronaphthalene and p-menthane; halogenated hydrocarbon solvents such as dichloromethane, chloroform, chlorobenzene, dichlorobenzene and trichlorobenzene; alcohol-based solvents such as methanol, ethanol, 1-propanol, 2-propanol and ethylene glycol; glycol-based solvents such as butyl carbitol; ether-based solvents such as THF, diethyl ether and dioxane; ketone-based solvents such as acetone, cyclohexanone and methyl ethyl ketone; and ester-based solvents such as ethyl acetate and butyl acetate, although this is not an exhaustive list. These solvents may be used individually, or two or more solvents may be mixed.

By performing heat curing in step (iii), the thus obtained patterned semi-cured film can form a completely cured film having the same shape as the photomask pattern.

The start time for curing of the photocurable silicone resin composition used in the present invention can be set freely by specifying the time of light irradiation, and therefore the photocurable silicone resin composition exhibits excellent pot life following preparation, and the composition can be stored at room temperature without the curing reaction progressing, and without any increase in the viscosity of the composition.

### <Step (iii)>

In step (iii), the thin film in a semi-cured state obtained in step (ii) is completely cured by heating. Because the thin film is in a semi-cured state, the resin composition does not flow during the heating, and curing can be performed with the initially intended thickness and shape maintained. The heat curing is performed at a temperature within a range from 25 to 200°C, and preferably from 100 to 180°C, for a period of 3 minutes to 72 hours, and preferably 1 to 6 hours. The heat curing conditions may be set appropriately so as to achieve a good balance between operating conditions and productivity, and the heat resistance of the light emitting element and the casing. In those cases where transfer molding or injection molding is used, molding is preferably performed at a temperature of 150 to 180°C and a pressure of 20 to 50 kgf/cm² for a period of 1 to 5 minutes. Further, post-curing (or secondary curing) may be performed at 150 to 200°C for 1 to 4 hours. The resulting cured thin film has a thickness of not more than 1 mm, preferably not more than 0.1 mm, and more preferably within a range from 0.01 to 0.1 mm.

The cured film obtained using the method of the present invention exhibits excellent heat resistance and optical transparency. Further, at a thickness of 1 mm and a temperature of 23°C, the cured film has a transmittance for light of wavelength 450 nm that is within a range from 90 to 100%, and preferably from 95 to 100%. Accordingly, the cured film can be used favorably as an encapsulating material for optical semiconductor elements such as light emitting diodes (LED), organic electroluminescent elements (organic EL), laser diodes and LED arrays.

There are no particular limitations on the configuration employed for encapsulating an optical semiconductor element with the cured film obtained using the method of the present invention, and for example, a method may be used in which the photocurable silicone resin composition described above is used to cover an optical semiconductor element disposed inside a casing having an opening, and the resin composition is then cured. Alternatively, an optical semiconductor element may be mounted on a matrix-type substrate, and a printing method, transfer molding method, injection molding method or compression molding method then used to encapsulate the optical semiconductor element with the photocurable silicone resin composition. In those cases where the optical semiconductor element is coated and protected using a potting or injection method, the composition is preferably a liquid.

### EXAMPLES

The present invention is described below in further detail based on a series of examples and comparative examples, but the present invention is in no way limited by the examples presented below. In the following description, the units "parts" refer to "parts by mass". Viscosity values refer to values measured at 23°C (using a digital viscometer DV-II+ Pro, manufactured by Brookfield Engineering Labs, Inc.).
- Materials Used -
- (A) Alkenyl group-containing organopolysiloxane

A branched polymethylvinylsiloxane comprising 16 mol% of SiO₂ units, 20 mol% of (CH₃)₃SiO_{1/2} units, 4 mol% of Vi(CH₃)₂SiO_{1/2} units and 60 mol% of (CH₃)₂SiO units, having a viscosity of 40 Pa·s, and containing 54 mmol of vinyl groups per 100 g of the compound (polystyrene-equivalent weight-average molecular weight determined by GPC: 63,000, manufactured by Shin-Etsu Chemical Co., Ltd.). The organopolysiloxane contains 34 vinyl groups per molecule.

### - (B) Organohydrogenpolysiloxane

A methylhydrogenpolysiloxane represented by a formula shown below (amount of SiH groups: 1.56 mol/100 g, viscosity: 5 mPa·s, manufactured by Shin-Etsu Chemical Co., Ltd.).

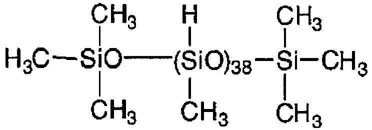

### - (C) Photoactive catalysts

(C-1): bis(acetylacetonato)platinum(II) (manufactured by Tokyo Kasei Kogyo Co., Ltd.)

(C-2): trimethyl(methylcyclopentadienyl)platinum (manufactured by Sigma-Aldrich Japan Co. LLC.)

### - (C') Non-photoactive catalyst

(C'-1): platinum vinylsiloxane complex (manufactured by Shin-Etsu Chemical Co., Ltd.)

### - Curing retarder

Acetylene alcohol-based ethynylcyclohexanol (manufactured by Shin-Etsu Chemical Co., Ltd.)

### [Preparation Examples 1, 2]

### - Preparation of photocurable silicone resin compositions 1 and 2 -

In each preparation example, the components shown in Table 1 were combined in the amounts and relative composition shown, and were mixed uniformly in a mixer and then degassed, yielding a colorless and transparent liquid composition. In Table 1, the amount of the platinum catalyst represents the equivalent amount of platinum metal (by mass) relative to the combined mass of the component (A) and the component (B).

In Table 1, the value "SiH groups/Vi groups" represents the molar ratio of the amount of SiH groups within the organohydrogenpolysiloxane of the component (B) relative to the total amount of vinyl groups within the organopolysiloxane of the component (A).

### [Preparation Example 3]

### - Preparation of non-photocurable silicone resin composition 3 -

The components shown in Table 1 were combined in the amounts and relative composition shown, and were mixed uniformly in a mixer and then degassed, yielding a colorless and transparent liquid composition. In Table 1, the amount of the platinum catalyst represents the equivalent amount of platinum metal (by mass) relative to the combined mass of the component (A) and the component (B).

### - Evaluation of pot life -

In the present description, the pot life of a silicone resin composition refers to the time taken, when all of the components are mixed together to prepare the composition and the composition is then left to stand at 23°C, for the viscosity to increase over time to a value that is twice that of the initial viscosity measured immediately following preparation.

Each of the silicone resin compositions 1 to 3 prepared in the preparation examples 1 to 3 was placed in a brown-colored bottle, and the brown bottle was then immersed in a constant temperature bath at 23°C and left for 2 weeks. After two weeks had elapsed, the viscosity was measured, and the degree of change in the viscosity from the initial viscosity value was determined. The results are shown in Table 1.

**[Table 1]**

| | Preparation Example 1 | Preparation Example 2 | Preparation Example 3 |
|---|---|---|---|
| Silione resin composition | 1 | 2 | 3 |
| (A) Organopolysiloxane (parts) | 100 | 100 | 100 |
| (B) Organohydrogenpolysiloxane (parts) | 3.8 | 3.8 | 3.8 |
| (C-1) bis(acetylacetonato)platinum(II) | 5 ppm | | |
| (C-2) trimethyl(methylcyclopentadienyl)platinum | | 5 ppm | |
| (C'-1) platinum vinylsiloxane complex | | | 5 ppm |
| Curing retarder (parts) | | | 0.25 |
| SiH groups/Vi groups | 1.1 | 1.1 | 1.1 |
| Initial viscosity (Pa·s) | 6.47 | 6.39 | 7.02 |
| Viscosity after 2 weeks (Pa·s) | 8.19 | 7.65 | measurement impossible |
| Change in viscosity | 1.27 times | 1.2 times | cured after 3 |
| | | | days |

### <Evaluations>

In the case of the silicone resin composition 3 that used the non-photoactive platinum catalyst, because the catalyst exhibited activity even without the irradiation of light, the composition cured in 3 days despite the addition of the curing retarder. It was evident that the pot life was extremely short, meaning the practical applicability of the composition was poor.

The photocurable silicone resin compositions 1 and 2 according to the present invention displayed an increase in viscosity of 1.2 to approximately 1.3 times even after 2 weeks had elapsed following preparation, confirming that the pot life exceeded 2 weeks.

### - Formation of patterned thin films on silicon wafers -

### [Example 1]

The silicone resin composition 1 was diluted with toluene to form a solution having a viscosity of not more than 10 mPa·s, and the solution was then applied to a 6-inch p-type silicon wafer by spin coating at 4,000 rpm over an operating time of 60 seconds, thus forming a coating film. During the coating operation, most of the toluene solvent evaporated.

A spacer of thickness 0.18 mm, a glass plate of thickness 1 mm, a lead frame used for pattern formation, and a 365 nm band pass filter (manufactured by Ushio Inc.) were stacked sequentially on top of the obtained coating film, and a conveyor-type UV irradiation apparatus (manufactured by Iwasaki Electric Co., Ltd.) was used to irradiate the coating film with an integral of light of 800 mJ/cm². Subsequently, the surface of the wafer was washed and developed with hexane, leaving a patterned thin film on the wafer surface. Subsequently, the wafer was placed in a dryer and cured by heating at 150°C for 60 minutes, thus obtaining a patterned cured thin film.

FIG. 1 illustrates, as a dashed line, the spectrum of light that was not passed through the aforementioned band pass filter, and illustrates, as a solid line, the spectrum of light that was passed through the band pass filter.

### [Example 2]

With the exception of using the silicone resin composition 2 instead of the silicone resin composition 1, processing was performed in the same manner as the example 1. A patterned cured thin film was obtained.

### [Comparative Example 1]

With the exception of using the silicone resin composition 3 instead of the silicone resin composition 1, processing was attempted in the same manner as the example 1. However, during the developing treatment, the entire film was washed off and removed from the wafer surface.

### [Examples 3 to 5]

In each of the examples 3 to 5, the silicone resin composition 1 was diluted with toluene to form a solution having a viscosity of not more than 10 mPa·s. The thus obtaining coating solution was then applied to a 6-inch p-type silicon wafer by spin coating over an operating time of 60 seconds. In the examples 3, 4 and 5, the speed of revolution during the spin coating was set to 5,000 rpm, 6,000 rpm and 7,000 rpm respectively. In each example, the obtained coating film was irradiated with light, subjected to a developing treatment with hexane, and then cured by heating in the same manner as that described for the example 1. As a result, patterned cured films having the thickness values shown in Table 2 were obtained.

### [Comparative Examples 2, 3]

Light having the spectrum shown by the dashed line in FIG. 1, which had not passed through the band pass filter, was used as the light irradiated onto the coating film. This light included wavelengths across a range from 200 to 600 nm, wherein the maximum peak wavelength was at 380 nm, and the spectral irradiance at a wavelength of 270 nm, which represents a smaller wavelength than 300 nm, was 17% of the spectral irradiance at the maximum peak wavelength. With the exception of using this light, coating film formation, light irradiation, and the developing treatment with hexane were attempted in the same manner as that described for the example 1, but the film was washed away during the developing treatment, and a patterned cured film could not be obtained.

### - Evaluation of Patterning -

In those cases where a patterned cured film having a uniform thickness and the desired shape was obtained, the patterning was evaluated as "good". In those cases where either a patterned cured film was not formed, or a patterned film was formed but the thickness uniformity or the shape precision was unsatisfactory, the patterning was evaluated as "poor".

**[Table 2]**

| | Example | | | | | Comparative example | | |
|---|---|---|---|---|---|---|---|---|
| | 1 | 2 | 3 | 4 | 5 | 1 | 2 | 3 |
| Silicone resin composition | 1 | 2 | 1 | 1 | 1 | 3 | 1 | 2 |
| Revolution speed during spin coating (rpm) | 4000 | 4000 | 5000 | 6000 | 7000 | 4000 | 4000 | 4000 |
| Wavelength of irradiated light (nm) | 365 | 365 | 365 | 365 | 365 | 365 | 200 to 400 | 200 to 400 |
| Cured film thickness (µm) | 40 | 40 | 25 | 20 | 10 | Coating film washed away during developing | Coating film washed away during developing | Coating film washed away during developing |
| Patterning evaluation | good | good | good | good | good | poor | poor | poor |

### <Evaluations>

In the examples 1 to 5, cured films having a uniform thickness and a high-precision pattern of the desired shape were formed.

In the comparative examples 2 and 3, despite the use of a photoactive catalyst, the irradiated films were washed away by the developing liquid (hexane) during the developing treatment, and a pattern was not formed.

The method of producing a cured film according to the present invention enables a cured film having a desired thickness and shape to be formed easily and with good precision, in a manner similar to a method that uses an n-type photoresist. The photocurable silicone resin composition used in the present invention has excellent pot life, meaning workability is good, and the obtained thin film exhibits excellent heat resistance and optical transparency, meaning the composition can be used favorably for encapsulating optical semiconductor elements such as light emitting diodes.

## Claims

1. A method of producing a cured thin film by curing a photocurable silicone resin composition comprising:
(A) an organopolysiloxane having two or more alkenyl groups within each molecule,
(B) an organohydrogenpolysiloxane having two or more hydrogen atoms bonded to silicon atoms within each molecule, in an amount that is sufficient to provide from 0.1 to 4.0 mols of hydrogen atoms bonded to silicon atoms per 1 mol of alkenyl groups within the composition, and
(C) an effective amount of a photoactive catalyst,
wherein the method comprises:
(i) obtaining a coating film by applying the silicone resin composition to a substrate,
(ii) obtaining a thin film in a semi-cured state by partially curing the coating film by irradiation with a light that is irradiated through a mask that is used for forming a pattern, thus forming a patterned thin film in a semi-cured state, the thin film being then subjected to a developing treatment to remove uncured portions, and
(iii) heating the patterned thin film in a semi-cured state to achieve complete curing,
and
wherein a spectrum of the light irradiated in step (ii) has a maximum peak in a wavelength region from 300 nm to 400 nm, and
a spectral irradiance of light of any wavelength in the spectrum within a wavelength region shorter than 300 nm is not more than 5% of a spectral irradiance of light of the maximum peak wavelength.

2. The method of producing a cured thin film according to claim 1, wherein the light irradiated in step (ii) is passed through an optical filter to remove a wavelength region of the emission spectrum shorter than 300 nm, thus ensuring that a spectral irradiance of light of any wavelength within the wavelength region shorter than 300 nm is not more than 5% of a spectral irradiance of light of the maximum peak wavelength.

3. The method of producing a cured thin film according to any one of claims 1 to 2, wherein the organopolysiloxane of component (A) comprises SiO_{4/2} units and R₃SiO_{1/2} units,
and each R independently represents an unsubstituted or substituted monovalent hydrocarbon group of 1 to 10 carbon atoms.

4. The method of producing a cured thin film according to claim 3, wherein the organopolysiloxane of component (A) further comprises R₂SiO units and/or RSiO_{3/2} units, and R is as defined above.

5. The method of producing a cured thin film according to claim 3, wherein the organopolysiloxane of component (A) further comprises R₂SiO units, and R is as defined above.

6. The method of producing a cured thin film according to any one of claims 1 to 4, wherein component (C) is selected from a β-diketonate platinum complex catalyst, bis(acetylacetonato)platinum complex catalyst, and a mixture thereof.

7. A cured thin film, obtained using the method defined in any one of claims 1 to 6, and having a thickness within the range from 0.01 to 1 mm.

8. A semiconductor device, comprising the cured thin film defined in claim 7.

## Patentansprüche

1. Verfahren zur Herstellung eines gehärteten Dünnfilms durch Härtung einer lichthärtbaren Siliconharzzusammensetzung, die Folgendes umfasst:
(A)ein Organopolysiloxan mit zwei oder mehr Alkenylgruppen in jedem Molekül,
(B) ein Organohydrogenpolysiloxan mit zwei oder mehr an die Si-Atome in jedem Molekül gebundenen Wasserstoffatomen in einer Menge, die ausreicht, um 0,1 - 4,0 mol an die Si-Atome gebundene Wasserstoffatome pro 1 mol Alkenylgruppen in der Zusammensetzung zu gewährleisten, und
(C) eine wirksame Menge eines lichtaktiven Katalysators,
wobei das Verfahren folgende Schritte umfasst:
(i) Herstellung eines Beschichtungsfilms durch Aufbringen der
Siliconharzzusammensetzung auf ein Substrat,
(ii) Herstellung eines Dünnfilms in einem halbgehärteten Zustand durch Teilhärtung des Beschichtungsfilms durch Bestrahlung mit einem Licht durch eine Maske, die zur Bildung eines Musters verwendet wird, wodurch ein gemusterter Dünnfilm in einem halbgehärteten Zustand hergestellt wird, der dann einer Entwicklungsbehandlung zur Entfernung der ungehärteten Anteile unterworfen wird, und
(iii) Erwärmung des gemusterten Dünnfilms in einem halbgehärteten Zustand zur
vollständigen Härtung, und
wobei das Spektrum des Lichts zur Bestrahlung in Schritt (ii) einen maximalen Peak in einem Wellenlängenbereich von 300 - 400 nm aufweist, und
eine Spektralstrahlungsintensität eines Lichts von beliebiger Wellenlänge im Spektrum innerhalb eines Wellenlängebereichs von unter 300 nm nicht mehr als 5 % einer Spektralstrahlungsintensität eines Lichts bei der Wellenlänge des maximalen Peaks ausmacht.

2. Verfahren zur Herstellung eines gehärteten Dünnfilms nach Anspruch 1, wobei das zur Bestrahlung verwendete Licht in Schritt (ii) durch einen optischen Filter geführt wird, um einen Wellenlängebereich des Emissionsspektrums von unter 300 nm zu entfernen, um auf diese Weise zu gewährleisten, dass die Spektralstrahlungsintensität eines Lichts von beliebiger Wellenlänge innerhalb des Wellenlängebereichs von unter 300 nm nicht mehr als 5 % einer Spektralstrahlungsintensität eines Lichts bei der Wellenlänge des maximalen Peaks ausmacht.

3. Verfahren zur Herstellung eines gehärteten Dünnfilms nach einem der Ansprüche 1 oder 2, wobei das Organopolysiloxan der Komponente (A) SiO_{4/2}-Einheiten und R₃SiO_{1/2}-Einheiten umfasst und jedes R unabhängig eine unsubstituierte oder substituierte einwertige Kohlenwasserstoffgruppe mit 1 bis 10 Kohlenstoffatomen darstellt.

4. Verfahren zur Herstellung eines gehärteten Dünnfilms nach Anspruch 3, wobei das Organopolysiloxan der Komponente (A) außerdem noch R₂SiO-Einheiten und/oder RSiO_{3/2}-Einheiten umfasst, und R wie oben definiert ist.

5. Verfahren zur Herstellung eines gehärteten Dünnfilms nach Anspruch 3, wobei das Organopolysiloxan der Komponente (A) außerdem noch R₂SiO-Einheiten umfasst, und R wie oben definiert ist.

6. Verfahren zur Herstellung eines gehärteten Dünnfilms nach einem der Ansprüche 1 oder 4, wobei die Komponente (C) ausgewählt wird unter einem β-Diketon-Pt-komplex-Katalysator, einem Bis(acetylacetonato)-Pt-komplex-Katalysator und einem Gemisch davon.

7. Gehärteter Dünnfilm, erhalten nach dem in einem der Ansprüche 1 bis 6 definierten Verfahren mit einer Dicke im Bereich von 0,01 - 1 mm.

8. Halbleitervorrichtung, die den in Anspruch 7 definierten gehärteten Dünnfilm umfasst.

## Revendications

1. Procédé pour la production d'un film mince durci par durcissement d'une composition de résine de silicone photodurcissable comprenant :
(A) un organopolysiloxane contenant deux groupes alcényle ou plus au sein de chaque molécule ;
(B) un organohydrogénopolysiloxane contenant deux atomes d'hydrogène ou plus liés à des atomes de silicium au sein de chaque molécule, en une quantité qui est suffisante pour obtenir de 0,1 à 4,0 moles d'atomes d'hydrogène liés à des atomes de silicium par mole de groupes alcényle au sein de la composition ;
(C) une quantité efficace d'un catalyseur photoactif ;
dans lequel le procédé comprend :
(i) l'obtention d'un film d'enduction par application de la composition de résine de silicone sur un substrat ;
(ii) l'obtention d'un film mince à l'état semi-durci par durcissement partiel du film d'enduction via une exposition à un rayonnement lumineux qui est irradié à travers un masque que l'on utilise pour la formation d'un motif, pour ainsi former un film mince contenant un motif à l'état semi-durci, le film mince étant ensuite soumis à un traitement de développement pour éliminer les portions non durcies ; et
(iii) chauffer le film mince muni d'un motif à l'état semi-durci pour obtenir un durcissement complet ;
et
dans lequel le spectre de la lumière irradiée à l'étape (ii) possède un pic maximal dans la gamme de longueurs d'ondes de 300 nm à 400 nm, et l'éclairement énergétique spectral de la lumière de n'importe quelle longueur d'onde dans le spectre au sein d'une gamme de longueurs d'ondes inférieure à 300 nm ne représente pas plus de 5 % d'un éclairement énergétique spectral de la lumière de la longueur d'onde du pic maximal.

2. Procédé de production d'un film mince durci selon la revendication 1, dans lequel on fait passer la lumière irradiée à l'étape (ii) à travers un filtre optique pour éliminer une gamme de longueurs d'onde du spectre d'émission inférieure à 300 nm, pour ainsi garantir le fait que l'éclairement énergétique spectral de la lumière de n'importe quelle longueur d'onde au sein de la gamme de longueurs d'ondes inférieure à 300 nm ne représente pas plus de 5 % d'un éclairement énergétique spectral de la lumière de la longueur d'onde du pic maximal.

3. Procédé de production d'un film mince durci selon la revendication 1 ou 2, dans lequel l'organopolysiloxane du composant (A) comprend des unités SiO_{4/2} et des unités R₃SiO_{1/2}, et chaque R représente, de manière indépendante, un groupe d'hydrocarbure monovalent non substitué ou substitué contenant de 1 à 10 atomes de carbone.

4. Procédé de production d'un film mince durci selon la revendication 3, dans lequel l'organopolysiloxane du composant (A) comprend en outres des unités R₂SiO et/ou des unités RSiO_{3/2}, et R est tel que défini ci-dessus.

5. Procédé de production d'un film mince durci selon la revendication 3, dans lequel l'organopolysiloxane du composant (A) comprend en outres des unités R₂SiO, et R est tel que défini ci-dessus.

6. Procédé de production d'un film mince durci selon l'une quelconque des revendications 1 à 4, dans lequel le composant (C) est choisi parmi un catalyseur de complexe de β-dicétonate platine, un catalyseur de complexe de bis(acétylacétonato)platine, et un de leurs mélanges.

7. Film mince durci que l'on obtient en utilisant le procédé défini dans l'une quelconque des revendications 1 à 6 et possédant une épaisseur dans la plage de 0,01 à 1 mm.

8. Dispositif à semi-conducteurs comprenant le film mince durci défini à la revendication 7.
